# EUROPEAN PATENT APPLICATION

(11) **EP 4 766 101 A1**
(43) Date of publication of application: **24.06.2026**
(21) Application number: 25219498.0
(22) Date of filing: 28.11.2025
(51) Int. Cl.: H10F 71/00, H10F 77/30

(54) **SOLAR CELL, PREPARATION METHOD THEREFOR, AND PHOTOVOLTAIC MODULE**

(30) Priority: 20.12.2024 CN 202411891722
(71) Applicant: HUAI'AN JIETAI NEW ENERGY TECHNOLOGY CO., LTD., Huaian City, Jiangsu 223400 (CN)
(72) Inventor: FAN, Xun, Huaian City, Jiangsu Province 223400 (CN); ZHANG, Mingming, Huaian City, Jiangsu Province 223400 (CN); FU, Shaojian, Huaian City, Jiangsu Province 223400 (CN); CUI, Gege, Huaian City, Jiangsu Province 223400 (CN)
(74) Representative: karo IP

(57) **Abstract**

The present disclosure relates to the field of solar cell technologies, and in particular, to a solar cell, a preparation method therefor, and a photovoltaic module. The solar cell is a sliced cell. A cutting surface of the sliced cell has a reflectivity of 10% to 90%, a roughness Ra of less than 1 µm, and a roughness Rz of less than 2 µm. A passivation layer is deposited on the cutting surface. A preparation method for a solar cell includes: performing non-destructive cutting on the solar cell to obtain a sliced cell; and depositing a passivation layer on an exposed cutting surface of the sliced cell using an atomic layer deposition technology. According to the present disclosure, a cutting damage is repaired by means of passivation, and cutting and passivation processes are also limited, to standardize an optimal matching value between cutting and passivation, achieve a state of complete repair of the cutting damage, and significantly improve a power generation power of a solar photovoltaic module.

## Description

The present disclosure relates to the field of solar cell technologies, and in particular, to a solar cell, a preparation method therefor, and a photovoltaic module.

With the development of a photovoltaic technology, improving the conversion efficiency of a solar cell has become a key goal. At present, the mainstream approach is to half-cut the solar cell, which is then packaged into a half-cut cell module. Half-cutting can reduce a current transmission distance inside the cell and reduce a resistance loss, thereby improving an output power of the cell. Meanwhile, during the production process, half-cutting enables more efficient use of raw materials such as silicon wafers. When silicon wafers have edge defects or inappropriate sizes, half-cutting can reduce waste, improve a material utilization rate, and reduce costs. Due to the reduced heat generation of the half-cut cell module, a thermal stress is also correspondingly reduced. This helps reduce the risk of deformation and damage of the half-cut cell module during long-term use, thereby improving the reliability and service life of the half-cut cell module. In a region where a temperature difference is large, the stability advantage of the half-cut cell module is more prominent. The half-cut cell module also has higher shade tolerance. This is because a parallel structure of half-cut cells allows current to continue flowing through other unshaded cells, thereby reducing a power loss caused by shading. In practical applications, such as building shading or dust accumulation, the half-cut cell module exhibits more stable performance.

However, in accordance with most of the approaches in the industry at present, the solar cell is directly packaged after being cut, which causes significant damage and sharp decrease in conversion efficiency. Therefore, surface recombination is reduced by passivating half-cut cells. However, existing cutting-then-passivation processes fail to determine mutual matching between cutting and passivation, making it impossible to fully and stably repair a cutting damage, which presents obvious drawbacks.

To solve the foregoing technical problems, the present disclosure provides a solar cell, a preparation method therefor, and a photovoltaic module according to the independent claims. Embodiments thereof are specified in the dependent claims.

To solve the foregoing technical problems, the present disclosure provides a solar cell, a preparation method therefor, and a photovoltaic module, which standardize cutting and passivation processes to achieve a state of complete repair of a cutting damage.

The present disclosure adopts the following technical solutions:
According to a first aspect, the present disclosure provides a solar cell. The solar cell is a sliced cell. A cutting surface of the sliced cell has a reflectivity of 10% to 90%, a roughness Ra of less than 1 µm, and a roughness Rz of less than 2 µm. A passivation layer is deposited on the cutting surface. The passivation layer has a refractive index of 1.52 to 1.78.

Optionally, the passivation layer has a thickness of 10 nm to 100 nm.

Optionally, a width of the passivation layer overhung on the cutting surface is less than 10 mm.

According to a second aspect, the present disclosure provides a preparation method for the foregoing solar cell, including the following steps:
(1) performing non-destructive cutting on the solar cell to obtain a sliced cell; and
(2) depositing a passivation layer on an exposed cutting surface of the sliced cell using an atomic layer deposition technology.

Optionally, the non-destructive cutting includes laser grooving followed by laser thermal cleavage cutting.

Optionally, grooving laser for the laser grooving has a power of 20 W to 200 W, and thermal cleavage laser for the laser thermal cleavage has a power of 50 W to 600 W.

Optionally, both the laser grooving and the laser thermal cleavage have a laser wavelength of 500 nm to 1200 nm.

Optionally, a deposition temperature during the passivation layer deposition process is 120°C to 450°C.

Optionally, the deposition is followed by an annealing treatment process, with an annealing temperature of 120°C to 400°C and an annealing time of 10 min to 60 min.

According to a third aspect, the present disclosure further provides a photovoltaic module, including the foregoing solar cell or a solar cell prepared from the foregoing process.

The present disclosure has the following beneficial effects:
According to the present disclosure, the cutting damage is repaired by means of passivation, and the reflectivity and roughness of the cutting surface of the sliced cell as well as the refractive index of the passivation layer are also limited, to standardize an optimal matching value between cutting and passivation, achieve a state of complete repair of the cutting damage, and significantly improve the power generation power of a photovoltaic module.

The technical solutions in examples of the present disclosure will be clearly and completely described below in conjunction with the examples of the present disclosure. It is apparent that the described examples are only a part of the examples of the present disclosure, rather than all the examples.

According to a first aspect, the present disclosure provides a solar cell. The solar cell is a sliced cell. A cutting surface of the sliced cell has a reflectivity of 10% to 90%, the roughness Ra of less than 1 µm, and the roughness Rz of less than 2 µm. A passivation layer is deposited on the cutting surface. The passivation layer has a refractive index of 1.52 to 1.78.

According to the present disclosure, the cutting damage is repaired by means of passivation, and cutting and passivation processes are also limited, to standardize an optimal matching value between cutting and passivation, achieve a state of complete repair of the cutting damage, and significantly improve the power generation power of a photovoltaic module. For the cutting surface, if the reflectivity and roughness thereof are not within the foregoing ranges, it indicates that the flatness of the cutting surface is poor, resulting in unevenness of the deposited passivation layer and reduced passivation performance. The limitation on the refractive index of the passivation layer also reflects the density of the passivation layer indirectly. Only when the passivation layer within the current refractive index range, the density thereof can meet passivation requirements. More specifically, the refractive index of the passivation layer is 1.52, 1.55, 1.58, 1.60, 1.62, 1.64, 1.67, 1.69, 1.70, 1.73, 1.75, 1.78, or a range value consisting of any two of the foregoing.

Specifically, in some examples of the present disclosure, a slicing position of the solar cell is the cutting surface formed by slicing the cell. The present disclosure does not limit a specific morphology of the cutting surface, nor does it specifically limit the number of cutting surfaces. The present disclosure also does not specifically limit the type of the solar cell, which may be a double-sided cell, a back-contact cell, or the like. The passivation layer deposited on the cutting surface may be a conventional passivation layer such as an aluminum oxide passivation layer, a silicon oxide passivation layer, or a silicon nitride passivation layer, which is not specifically limited in the present disclosure. Preferably, the passivation layer is an aluminum oxide passivation layer.

Specifically, in some examples of the present disclosure, the magnitude of roughness is tested in accordance with contact and non-contact profile testing methods for surface roughness and cutting line marks of silicon wafers for solar cells specified in the GB/T30860-2014 standard.

Specifically, in some examples of the present disclosure, the passivation layer has a thickness of 10 nm to 100 nm. More specifically, the thickness of the passivation layer is 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, or a range value consisting of any two of the foregoing point values. Preferably, the thickness of the passivation layer is 40 nm to 80 nm. By limiting the reflectivity, roughness, and the like of the cutting surface before passivation, a thickness difference of the passivation layer deposited at different positions of the cutting surface during the subsequent deposition process is small, basically within a range of ±2 nm. In addition, at the current passivation layer thickness, a good passivation effect can be achieved. If the thickness is small, the cell performance will be degraded.

Overhanging refers to the formation of a cutting surface passivation layer on the remaining surfaces of the cell except for the cutting surface. The solar cell of the present disclosure further includes a first side surface and a second side surface intersecting with the cutting surface. During the passivation process of the cutting surface, the passivation layer is overhung at positions of the first side surface and the second side surface close to the cutting surface.

Specifically, in some examples of the present disclosure, the width of the passivation layer overhung on the cutting surface is less than 10 mm.

In the present disclosure, the width of the overhung passivation layer is less than 10 mm, and the passivation layer overhung on the cutting surface does not cover an effective region of the cell. Although there is a carrier transport layer at an edge of the cell, there is no metal contact on this region to conduct current outward. Therefore, the passivation layer overhung on the cutting surface does not affect the operation and photoelectric conversion efficiency of the cell.

For the solar cell of the present disclosure, before depositing the passivation layer, the cells to be deposited are stacked and clamped by a clamping device, to control an edge overhanging width of the passivation layer, thereby ensuring that overhanging at the edge of the passivation layer has no negative impact on the conversion efficiency of the cell. Since the passivation layer, especially an aluminum oxide passivation layer, has a relatively low refractive index, the impact on cell performance is small under the current overhanging width. More specifically, the width of the passivation layer overhung on the cutting surface is 10 mm, 8 mm, 6 mm, 4 mm, 2 mm, 1 mm, 0.5 mm, 0.3 mm, 0.2 mm, 0.1 mm, or 0.05 mm. The width of the passivation layer overhung on the cutting surface according to the present disclosure is a maximum dimension of the cutting surface passivation layer overhung on the first side surface or the second side surface in a direction perpendicular to a cutting edge on the first side surface or the second side surface. If the cutting edge is a curve, the direction is perpendicular to a tangent line of the curve. Preferably, the width of the passivation layer overhung on the cutting surface is 0.05 mm to 0.3 mm.

According to a second aspect, the present disclosure provides a preparation method for the foregoing solar cell, including the following steps:
(1) Perform non-destructive cutting on the solar cell to obtain a sliced cell.
(2) Deposit aluminum oxide on an exposed cutting surface of the sliced cell using an atomic layer deposition technology to form a passivation layer.

Specifically, in some examples of the present disclosure, the non-destructive cutting includes laser grooving followed by laser thermal cleavage cutting. According to the present disclosure, laser pre-grooving on both sides of a cutting line of the solar cell isolates the cutting line and prevents the reduction of the photoelectric conversion efficiency of the sliced cell caused by a cutting damage on a cutting cross-section during a silicon wafer cutting process.

Specifically, in some examples of the present disclosure, grooving laser has a power of 20 W to 200 W, and thermal cleavage laser has a power of 50 W to 600 W. More specifically, the power of the grooving laser is 20 W, 30 W, 40 W, 50 W, 60 W, 80 W, 90 W, 100 W, 120 W, 140 W, 150 W, 160 W, 180 W, 200 W, or a range value consisting of any two of the foregoing point values. Preferably, the power of the grooving laser is 50 W to 150 W. The power of the thermal cleavage laser is 50 W, 80 W, 100 W, 120 W, 140 W, 150 W, 160 W, 180 W, 200 W, 240 W, 260 W, 300 W, 320 W, 360 W, 400 W, 420 W, 450 W, 480 W, 500 W, or a range value consisting of any two of the foregoing point values. Preferably, the power of the thermal cleavage laser is 200 W to 400 W.

Specifically, in some examples of the present disclosure, both the laser grooving and the laser thermal cleavage have a laser wavelength of 500 nm to 1200 nm. More specifically, both the laser grooving and the laser thermal cleavage have a laser wavelength of 532 nm to 1064 nm. Preferably, the laser wavelength of the laser grooving and the laser wavelength of the laser thermal cleavage are 532 nm, 798 nm, or 1064 nm.

Specifically, in some examples of the present disclosure, a laser for the laser grooving is a green picosecond laser or an ultraviolet picosecond laser.

More specifically, in some examples of the present disclosure, a silicon wafer in the solar cell for slicing has a resistivity of 0.3 Ω/cm to 1.8 Ω/cm, and pyramids formed after texturing front and back surfaces of the silicon wafer have a base height of 6 µm to 25 µm. The silicon wafer resistivity and pyramid base height of a conventional solar cell basically fall within the foregoing ranges, further indicating that the cutting and passivation processes of the present disclosure are basically applicable to conventional solar cell structures and have a wide application range.

Specifically, in some examples of the present disclosure, the non-destructive cutting may be either wet non-destructive cutting or dry non-destructive cutting, which is not specifically limited in the present disclosure. Any non-destructive cutting manner that can achieve the roughness and reflectivity of the cutting surface in the present disclosure shall fall within the protection scope of the present disclosure.

More specifically, as an embodiment, the present disclosure adopts dry non-destructive cutting, including the following steps. A cutting path of the solar cell is preset. During cutting, a spot center of the thermal cleavage laser coincides with a spot center of the grooving laser or follows behind the spot center of the grooving laser. The grooving laser moves along the cutting path and momentarily performs laser cutting at both ends of the solar cell or positions close to edges of both ends to form two short cleavage grooves. The thermal cleavage laser moves along the cutting path and scans the solar cell, to divide the solar cell into two cells along the cutting path, thereby completing cutting.

Specifically, in some examples of the present disclosure, before depositing the passivation layer using the atomic layer deposition technology, a plurality of non-destructively cut cells are stacked and clamped using a special fixture, and then the exposed cutting surfaces are deposited, thereby ensuring that an overhanging area at a passivation edge is extremely small, with no negative impact on the conversion efficiency.

Specifically, in some examples of the present disclosure, a deposition temperature during an aluminum oxide deposition process is 120°C to 450°C. More specifically, the deposition temperature is 120°C, 150°C, 180°C, 200°C, 220°C, 240°C, 250°C, 270°C, 300°C, 320°C, 350°C, 360°C, 380°C, 400°C, 420°C, 450°C, or a range value consisting of any two of the foregoing point values. Preferably, the deposition temperature is 200°C to 400°C.

Further, the deposition is followed by an annealing treatment process, with an annealing temperature of 120°C to 400°C and an annealing time of 10 min to 60 min. Specifically, in some examples of the present disclosure, the annealing temperature is 120°C, 150°C, 180°C, 200°C, 220°C, 240°C, 250°C, 270°C, 300°C, 320°C, 350°C, 360°C, 380°C, 400°C, or a range value consisting of any two of the foregoing point values. Preferably, the annealing temperature is 200°C to 350°C. The annealing time is 10 min, 12 min, 15 min, 18 min, 20 min, 22 min, 25 min, 28 min, 30 min, 32 min, 35 min, 38 min, 40 min, 42 min, 45 min, 48 min, 50 min, 53 min, 55 min, 57 min, 60 min, or a range value consisting of any two of the foregoing point values. Preferably, the annealing time is 25 min to 40 min.

According to a third aspect, the present disclosure further provides a photovoltaic module, including the foregoing solar cell or a solar cell prepared from the foregoing process.

Specifically, in some examples of the present disclosure, the photovoltaic module includes a plurality of mutually electrically connected cell strings. The cell strings may be connected in series or in parallel, which is not specifically limited in the present disclosure. For example, the photovoltaic module is obtained by connecting in series and packaging the foregoing solar cells.

The solar cell of the present disclosure will be further described below in conjunction with specific examples.

### Example 1

This example provides a solar cell. The solar cell is a sliced cell. A cutting surface of the sliced cell has a reflectivity of 70%, a roughness Ra of 0.8 µm, and a roughness Rz of 1.6 µm. An aluminum oxide passivation layer is deposited on the cutting surface. The passivation layer has a thickness of 60 nm. The passivation layer overhung on the cutting surface has a width of 5 mm and a refractive index of 1.62.

A preparation method for a solar cell in this example includes the following steps:
(1) Perform non-destructive cutting on the solar cell to obtain a sliced cell, where grooving laser has a power of 50 W, thermal cleavage laser has a power of 300 W, and the grooving laser and the thermal cleavage laser have a laser wavelength of 1064 nm.
(2) Deposit aluminum oxide on an exposed cutting surface of the sliced cell using an atomic layer deposition technology to form a passivation layer, where a deposition temperature is 200°C, the deposition is followed by an annealing treatment, with an annealing temperature of 300°C and an annealing time of 30 min.

### Example 2

This example provides a solar cell. The solar cell is a sliced cell. A cutting surface of the sliced cell has a reflectivity of 10%, a roughness Ra of 0.8 µm, and a roughness Rz of 1.6 µm. An aluminum oxide passivation layer is deposited on the cutting surface. The passivation layer has a thickness of 10 nm. The passivation layer overhung on the cutting surface has a width of 2 mm and a refractive index of 1.78.

A preparation method for a solar cell in this example includes the following steps:
(1) Perform non-destructive cutting on the solar cell to obtain a sliced cell, where grooving laser has a power of 20 W, thermal cleavage laser has a power of 50 W, and the grooving laser and the thermal cleavage laser have a laser wavelength of 798 nm.
(2) Deposit aluminum oxide on an exposed cutting surface of the sliced cell using an atomic layer deposition technology to form a passivation layer, where a deposition temperature is 120°C, the deposition is followed by an annealing treatment, with an annealing temperature of 120°C and an annealing time of 60 min.

### Example 3

This example provides a solar cell. The solar cell is a sliced cell. A cutting surface of the sliced cell has a reflectivity of 90%, a roughness Ra of 0.8 µm, and a roughness Rz of 1.6 µm. An aluminum oxide passivation layer is deposited on the cutting surface. The passivation layer has a thickness of 100 nm. The passivation layer overhung on the cutting surface has a width of 9 mm and a refractive index of 1.52.

A preparation method for a solar cell in this example includes the following steps:
(1) Perform non-destructive cutting on the solar cell to obtain a sliced cell, where grooving laser has a power of 200 W, thermal cleavage laser has a power of 600 W, and the grooving laser and the thermal cleavage laser have a laser wavelength of 532 nm.
(2) Deposit aluminum oxide on an exposed cutting surface of the sliced cell using an atomic layer deposition technology to form a passivation layer, where a deposition temperature is 450°C, the deposition is followed by an annealing treatment, with an annealing temperature of 400°C and an annealing time of 10 min.

### Comparative Example 1

This comparative example provides a solar cell. The solar cell is a sliced cell. A cutting surface of the sliced cell has a reflectivity of 50%, a roughness Ra of 2.4 µm, and a roughness Rz of 3.6 µm. An aluminum oxide passivation layer is deposited on the cutting surface. The passivation layer has a thickness of 10 nm. The passivation layer overhung on the cutting surface has a width of 5 mm and a refractive index of 1.62.

A preparation method for a solar cell in this comparative example includes the following steps:
(1) Perform non-destructive cutting on the solar cell to obtain a sliced cell, where grooving laser has a power of 10 W, thermal cleavage laser has a power of 30 W, and the grooving laser and the thermal cleavage laser have a laser wavelength of 1064 nm.
(2) Deposit aluminum oxide on an exposed cutting surface of the sliced cell using an atomic layer deposition technology to form a passivation layer, where a deposition temperature is 300°C, the deposition is followed by an annealing treatment, with an annealing temperature of 120°C and an annealing time of 60 min.

### Comparative Example 2

This comparative example provides a solar cell. The solar cell is a sliced cell. A cutting surface of the sliced cell has a reflectivity of 70%, a roughness Ra of 0.8 µm, and a roughness Rz of 1.6 µm. An aluminum oxide passivation layer is deposited on the cutting surface. The passivation layer has a thickness of 8 nm. The passivation layer overhung on the cutting surface has a width of 5 mm and a refractive index of 1.50.

A preparation method for a solar cell in this comparative example includes the following steps:
(1) Perform non-destructive cutting on the solar cell to obtain a sliced cell, where grooving laser has a power of 100 W, thermal cleavage laser has a power of 300 W, and the grooving laser and the thermal cleavage laser have a laser wavelength of 1064 nm.
(2) Deposit aluminum oxide on an exposed cutting surface of the sliced cell using an atomic layer deposition technology to form a passivation layer, where a deposition temperature is 300°C, the deposition is followed by an annealing treatment, with an annealing temperature of 120°C and an annealing time of 60 min.

### Comparative Example 3

This comparative example provides a solar cell. The solar cell is a sliced cell. A cutting surface of the sliced cell has a reflectivity of 70%, a roughness Ra of 0.8 µm, and a roughness Rz of 1.6 µm. An aluminum oxide passivation layer is deposited on the cutting surface. The passivation layer has a thickness of 105 nm. The passivation layer overhung on the cutting surface has a width of 5 mm and a refractive index of 1.80.

A preparation method for a solar cell in this comparative example includes the following steps:
(1) Perform non-destructive cutting on the solar cell to obtain a sliced cell, where grooving laser has a power of 100 W, thermal cleavage laser has a power of 300 W, and the grooving laser and the thermal cleavage laser have a laser wavelength of 1064 nm.
(2) Deposit aluminum oxide on an exposed cutting surface of the sliced cell using an atomic layer deposition technology to form a passivation layer, where a deposition temperature is 300°C, the deposition is followed by an annealing treatment, with an annealing temperature of 120°C and an annealing time of 60 min.

### Comparative Example 4

This comparative example provides a solar cell. The solar cell is a sliced cell. A cutting surface of the sliced cell has a reflectivity of 70%, a roughness Ra of 0.8 µm, and a roughness Rz of 1.6 µm. An aluminum oxide passivation layer is deposited on the cutting surface. The passivation layer has a thickness of 7 mm. The passivation layer overhung on the cutting surface has a width of 5 mm and a refractive index of 1.62.

A preparation method for a solar cell in this comparative example includes the following steps:
(1) Perform non-destructive cutting on the solar cell to obtain a sliced cell, where grooving laser has a power of 50 W, thermal cleavage laser has a power of 300 W, and the grooving laser and the thermal cleavage laser have a laser wavelength of 1064 nm.
(2) Deposit aluminum oxide on an exposed cutting surface of the sliced cell using an atomic layer deposition technology to form a passivation layer, where a deposition temperature is 300°C, the deposition is followed by an annealing treatment, with an annealing temperature of 120°C and an annealing time of 60 min.

The results of the cell performance tests of the solar cell in the examples and comparative examples, which were conducted before and after cutting and passivation, are shown in Table 1. A cutting-passivation gain refers to an optimization degree of the cell performance after passivation compared with that before passivation.

**Table 1**

| | | Eff (%) | Voc (mV) | Isc (A) | FF (%) |
|---|---|---|---|---|---|
| Example 1 | Cutting-passivation gain | 0.37 | 2.30 | 0.03 | 0.78 |
| Example 2 | Cutting-passivation gain | 0.14 | 0.50 | 0.01 | 0.34 |
| Example 3 | Cutting-passivation gain | 0.24 | 1.60 | 0.01 | 0.52 |
| Comparative Example 1 | Cutting-passivation gain | 0.11 | 1.0 | 0.00 | 0.23 |
| Comparative Example 2 | Cutting-passivation gain | -0.10 | -1.00 | -0.01 | -0.12 |
| Comparative Example 3 | Cutting-passivation gain | -0.07 | -0.91 | -0.01 | -0.07 |
| Comparative Example 4 | Cutting-passivation gain | -0.10 | -0.97 | -0.02 | -0.09 |

It can be seen from the test results in Table 1 that for the solar cell of the present disclosure, a cutting damage is repaired by means of passivation, and cutting and passivation processes are also limited, to standardize an optimal matching value between cutting and passivation, achieve a state of complete repair of the cutting damage, and significantly improve the performance of a solar photovoltaic module. It can be seen from the test results in Example 1 and Comparative Example 1 that when the roughness of the cutting surface is too large, the flatness of the cutting surface is poor, resulting in unevenness of the deposited passivation layer and an unsatisfactory improvement effect of passivation performance. It can be seen from the test results in Example 1 and Comparative Examples 2-4 that when the refractive index of the passivation layer is too large or too small or the thickness of the passivation layer is too small, the density of the passivation layer cannot meet passivation requirements, resulting in degradation of the cell performance after passivation.

The present disclosure has been further described above with reference to specific examples, but it should be understood that the specific descriptions herein should not be construed as limiting the essence and scope of the present disclosure.

## Claims

1. A solar cell, wherein the solar cell is a sliced cell, a cutting surface of the sliced cell has a reflectivity of 10% to 90%, a roughness Ra of less than 1 µm, and a roughness Rz of less than 2 µm, a passivation layer is deposited on the cutting surface, and the passivation layer has a refractive index of 1.52 to 1.78.

2. The solar cell according to claim 1, wherein the passivation layer has a thickness of 10 nm to 100 nm.

3. The solar cell according to claim 1, wherein the width of the passivation layer overhung on the cutting surface is less than 10 mm.

4. The solar cell according to any one of claims 3, wherein the solar cell comprises a first side surface and a second side surface intersecting with the cutting surface, and the passivation layer is overhung at positions of the first side surface and the second side surface close to the cutting surface;
the width of the passivation layer overhung on the cutting surface is a maximum dimension of the cutting surface passivation layer overhung on the first side surface or the second side surface in a direction perpendicular to a cutting edge on the first side surface or the second side surface, and if the cutting edge is a curve, the direction is perpendicular to a tangent line of the curve.

5. A preparation method for a solar cell according to any one of claims 1 to 4, comprising the following steps:
performing non-destructive cutting on the solar cell to obtain a sliced cell; and
depositing a passivation layer on an exposed cutting surface of the sliced cell using an atomic layer deposition technology.

6. The preparation method for a solar cell according to claim 5, wherein the non-destructive cutting comprises laser grooving followed by laser thermal cleavage cutting.

7. The preparation method for a solar cell according to claim 6, wherein grooving laser for the laser grooving has a power of 20 W to 200 W, and thermal cleavage laser for the laser thermal cleavage has a power of 50 W to 600 W.

8. The preparation method for a solar cell according to claim 6, wherein both the laser grooving and the laser thermal cleavage have a laser wavelength of 500 nm to 1200 nm.

9. The preparation method for a solar cell according to claim 5, wherein a deposition temperature during the passivation layer deposition process is 120°C to 450°C.

10. The preparation method for a solar cell according to claim 5, wherein the deposition is followed by an annealing treatment process, with an annealing temperature of 120°C to 400°C and an annealing time of 10 min to 60 min.

11. A photovoltaic module, comprising the solar cell according to any one of claims 1 to 4 or a solar cell prepared from the preparation method for a solar cell according to any one of claims 5 to 10.
